# EUROPÄISCHE PATENTSCHRIFT

(11) **EP 1 935 514 B1**
(45) Veröffentlichungstag und Bekanntmachung des Hinweises auf die Patenterteilung: **15.07.2009**
(21) Anmeldenummer: 06026053.6
(22) Anmeldetag: 18.12.2006
(51) Int. Cl.: B08B 3/02, H01L 21/00

(54) **Vorrichtung und Verfahren zum Reinigen von Gegenständen, insbesondere von dünnen Scheiben**
Apparatus and process for cleaning objects, in particular of thin discs
Appareil et procédé pour nettoyer des objects, en particulier de disques minces

(43) Veröffentlichungstag der Anmeldung: 25.06.2008
(73) Patentinhaber: Rena Sondermaschinen GmbH, 78148 Gütenbach (DE)
(72) Erfinder: Bürger, Norbert, 79199 Kirchzarten (DE)
(74) Vertreter: Stürken, Joachim

(56) Entgegenhaltungen:
- EP-A- 1 457 269
- WO-A1-00/29135
- DE-A1- 3 815 018
- DE-A1-7102004 018 81
- US-A- 4 358 204
- US-A- 6 139 591
- US-A1- 2004 025 901

## Beschreibung

### Technisches Gebiet

Die Erfindung betrifft allgemein eine Vorrichtung und ein Verfahren zum Reinigen von dünnen Scheiben, wie beispielsweise Halbleiterwafern, Glassubstraten, Fotomasken, Compactdiscs oder dergleichen. Insbesondere betrifft die Erfindung eine Vorrichtung und ein Verfahren zum Vorreinigen von Halbleiterwafern, nachdem diese durch Sägen aus einem Block hergestellt worden sind.

### Definitionen

Unter dem Begriff *"dünne Scheiben"* werden erfindungsgemäß solche Gegenstände verstanden, die eine sehr geringe Dicke im Bereich zwischen 80 und 300 µm wie z.B. 150 bis 170 µm aufweisen. Die Form der Scheiben ist beliebig und kann beispielsweise im Wesentlichen rund (Halbleiterwafer) oder im Wesentlichen rechteckig bzw. quadratisch (Solarwafer) sein, wobei die Ecken wahlweise eckig, abgerundet oder abgeschrägt ausgestaltet sein können. Diese Gegenstände sind aufgrund ihrer geringen Dicke sehr bruchempfindlich. Die Erfindung bezieht sich auf die Vorreinigung derartiger Gegenstände.

Die erfindungsgemäße Vorrichtung und das erfindungsgemäße Verfahren werden nachfolgend aus Verständnisgründen exemplarisch anhand von eckigen Solarwafern (kurz "Wafern") erläutert.

Die Erfindung beschränkt sich jedoch nicht nur auf die Vorreinigung von Wafern. Vielmehr umfasst die Erfindung allgemein die Reinigung von dünnen Scheiben, die sequenziell in einem definierten Abstand zueinander in einer Trägereinrichtung gehalten werden.

### Hintergrund der Erfindung

Für die Herstellung von Wafern ist es notwendig, das Ausgangsmaterial, das in der Regel als rechteckiger Siliziumblock vorliegt und als Substratblock bzw. Ingot bezeichnet wird, auf eine Trägereinrichtung aufzubringen. Diese Trägereinrichtung besteht typischerweise aus einem Metallträger, auf dem wiederum eine Glasplatte als Trägermaterial angebracht ist. Dabei ist der zu bearbeitende Substratblock auf der Glasplatte aufgeklebt. Alternativ hierzu können jedoch auch andere Materialien für die Ausbildung der Trägereinrichtung vorgesehen sein.

Zur Herstellung mehrerer Wafer ist es notwendig, den Substratblock aus mono- oder polykristallinem Silizium scheibenartig vollständig durchzusägen, so dass der jeweilige Sägeschnitt bis in die Glasplatte hineinreicht. Nach dem Sägen z.B. unter Verwendung herkömmlicher Innenlochsägen oder Drahtsägen haftet der auf diese Weise hergestellte Wafer mit einer Längsseite (Kante), nämlich mit derjenigen, die der Trägereinrichtung zugewandt ist, durch die Klebeverbindung weiterhin an der Glasplatte. Nachdem der Substratblock vollständig in einzelne Wafer zerteilt worden ist und sich zwischen den einzelnen Wafern somit ein spaltartiger Zwischenraum gebildet hat, liegt der ursprüngliche Substratblock in Form eines kammartigen, fächerartigen Gebildes vor.

Zur Durchführung des nassmechanischen Sägeprozesses unter Verwendung einer Präzisionsdrahtsäge werden im Wesentlichen zwei Materialien benötigt, zum einen Siliziumcarbid oder gleichwirkende Partikel mit abrasiven Eigenschaften für die nötige Härte, zum anderen Glykol oder auch Öl als Träger- und Kühlmittel. Korrekt betrachtet ist es gar nicht der Draht, der am Silizium sägt, sondern vielmehr sind es die Siliziumcarbidpartikel, die mit Glykol wie z.B. Polyethylenglykol oder Öl vermengt als sogenannte "Slurry" die Arbeit verrichten. Mit diesem gegebenenfalls weitere chemische Zusätze enthaltenden Medium wird der Draht während des Sägevorgangs gespült. Durch die Bewegung des Drahtes entfalten die Partikel ihre abrasive, d.h. abtragende Wirkung. So werden beispielsweise bei jedem Einschnitt mit einem 160-Mikrometer-Draht ca. 210 Mikrometer Silizium zerrieben. Dieser Verschnitt wird auch als Kerf bezeichnet und kann unter Verwendung dünnerer Drähte mit Duchmessern von z.B. 80 Mikrometer reduziert werden. Während des Sägeprozesses kommt es zu einer Vielzahl von chemischen Reaktionen der beteiligten Reaktionspartner auch an der Waferoberfläche. Zwischen den Wafern befinden sich nach dem Sägen Slurry, Reaktionsprodukte und Konglomerate aus Slurry-Bestandteilen und Silizium, die aufgrund ihrer Konsistenz häufig an der Oberfläche des Wafers anhaften.

Bevor die einzelnen Wafer, die nun jeweils eine scheibenförmige Ausbildung aufweisen, von der Trägereinrichtung entfernt werden, findet eine Vorreinigung (Pre-Cleaning) statt. Durch die Vorreinigung soll die Slurry, die sich in den entstandenen Zwischenräumen jeweils zweier Substrate auf den Oberflächen der Wafer befindet, herausgewaschen werden. Diese Vorreinigung ist Gegenstand der vorliegenden Erfindung.

### Stand der Technik

Aus dem Stand der Technik sind Vorreinigungen zur Entfernung der Slurry bekannt. Sie werden in der Regel von Hand durchgeführt, indem ein Duschkopf, aus dem ein Fluidstrom austritt, von Hand über das kammartige Gebilde geführt wird. Dadurch wird erreicht, dass die in den Spalten des Substratblocks befindliche Slurry zumindest zum Teil ausgeschwemmt wird. Ein überwiegender Anteil verbleibt jedoch in dem spaltartigen Zwischenraum.

Diese manuelle Behandlung gestaltet sich jedoch schwierig, da die Trägereinrichtung von allen Seiten abzuduschen ist und ein Ablaufen der Slurry aufgrund des ständigen Drehens nur teilweise möglich ist. Zudem besteht gerade durch das ständige Wenden der Trägereinrichtung die Gefahr, dass die einzelnen Wafer von der Glasplatte abbrechen und zerstört werden.

Bis die Trägereinrichtung mit den Wafern einem nachfolgenden Bearbeitungsprozess übergeben werden kann, sind die Oberflächen der Wafer in der Regel bereits abgetrocknet. Ferner haftet dort weiterhin Slurry, wodurch der weitere Bearbeitungsprozess stark beeinflusst wird.

Ein gemeinsamer Nachteil dieser manuellen Behandlung liegt darin, dass eine gleichbleibende Qualität und damit standardisierbare und reproduzierbare Ergebnisse bezüglich der Oberflächeneigenschaften nicht gewährleistet werden können.

Die US 6,139,591 A beschreibt eine Anlage zur Vereinzelung und Reinigung von Wafern, die einen Abschnitt zur Vorreinigung umfasst, in welchem die in einem gesägten Substratblock vorliegenden, noch nicht vereinzelten Wafer zur Entfernung der Slurry aus den Zwischenräumen innerhalb eines mit Reinigungsflüssigkeit gefüllten Beckens abgeduscht werden.

### Aufgabe der Erfindung

Die Aufgabe der vorliegenden Erfindung besteht daher in der Bereitstellung einer Vorrichtung und eines Verfahrens, mit denen die Slurry zumindest teilweise aus den Zwischenräumen benachbarter dünner Scheiben automatisch entfernt werden kann.

### Lösung der Aufgabe

Der Kerngedanke der Erfindung ist es, eine Vorrichtung und ein Verfahren vorzuschlagen, mit denen der in unterschiedliche Verfahrensschritte gegliederte Reinigungsprozess selbsttätig (automatisch) durchlaufen wird.

Die erfindungsgemäße Vorrichtung ist Gegenstand des Anspruchs 1, während das erfindungsgemäße Verfahren durch die Merkmale des Anspruchs 10 definiert wird. Bevorzugte Ausführungsformen sind Gegenstand jeweiliger Unteransprüche.

### Vorteile der Erfindung

Um ein weitgehendes Entfernen der Slurry aus den Zwischenräumen zu ermöglichen, wird eine Vorrichtung vorgeschlagen, die im Wesentlichen aus einer Duscheinrichtung, einem Becken, sowie einer Schwenkeinrichtung besteht.

Die Trägereinrichtung, die mindestens aus dem Trägermaterial besteht, auf dem der Substratblock aufgebracht ist, umfasst die durch Sägen des Substratblocks erzeugten dünnen Scheiben (wie bspw. Wafer). Diese sind sequenziell, d.h. nacheinander aufgereiht, wobei zwischen den einzelnen Wafern jeweils ein Zwischenraum ausgebildet ist. Die Duscheinrichtung ist derart ausgestaltet, dass sie vorzugsweise über die gesamte Längserstreckung der Wafer einen Fluidstrom überwiegend in die Zwischenräume erzeugt. Der gesamte Reinigungsprozess ist in einem mit Fluid befüllbaren Becken vorgesehen. Das Becken ist derart bemessen, dass die Trägereinrichtung vollständig darin Platz findet.

Während des Duschvorgangs ist das Becken nicht gefüllt. Es dient vielmehr dazu, das durch die Wafer strömende Fluid zu sammeln und abzuführen. Nach einer bevorzugten Ausführungsform erfolgt der Duschvorgang in einem Becken, dessen Füllstand derart eingestellt wird, dass sich der untere Teil des Substratblocks (10 bis 50%, besonders bevorzugt ca. 30% der Waferfläche) in der Flüssigkeit befindet.

Die Ausgangslage des Reinigungsprozesses ist derart bestimmt, dass die Trägereinrichtung in eine "korbartige" Hilfseinrichtung der erfindungsgemäßen Vorrichtung übergeben wird. Die Ausgestaltung dieser Hilfseinrichtung ist grundsätzlich nicht festgelegt, solange gewährleistet ist, dass das Fluid die Zwischenräume zwischen den Wafern im Wesentlichen ungehindert erreichen kann und der Substratblock sowie gegebenenfalls abgelöste Wafer sicher gehalten werden. Nach einer bevorzugten Ausführungsform wird diese Einrichtung in Form zweier parallel zueinander in Längsrichtung verlaufender Stangenpaare bereitgestellt, wobei ein Paar als Auflage dient und ein weiteres Paar die Wafer seitlich stützt. Sobald die Hilfseinrichtung in die Vorrichtung eingebracht ist, ist das kammartige Gebilde des auf der Trägereinrichtung fixierten Substratblocks derart ausgerichtet, dass die Zwischenräume sowohl zu den Seitenwänden als auch zum Boden des Beckens offen und damit frei zugänglich sind. In dieser Ausgangslage befindet sich die Trägereinrichtung oberhalb der von ihr getragenen Substrate.

Die Hilfseinrichtung wird vorteilhafterweise in eine Schwenkeinrichtung eingehängt. Damit ist es möglich, die die Wafer umfassende Hilfseinrichtung innerhalb des Beckens zu bewegen. Die erfindungsgemäße Vorrichtung sieht vor, dass die Hilfseinrichtung innerhalb des Beckens mindestens um 180 Grad verschwenkbar ist. Vorteilhafterweise ist die Vorrichtung derart gestaltet, dass von der beschriebenen Ausgangslage in beide Richtungen eine Verschwenkung um 90 Grad möglich ist.

Dem nachfolgend dargelegten ersten Schritt des erfindungsgemäßen Reinigungsprozesses kann vorteilhafterweise eine Glykolvorlagerung der zu behandelnden Substrate vorgeschaltet sein.

Für den ersten Schritt des erfindungsgemäßen Reinigungsprozesses ist nun vorgesehen, eine Duscheinrichung zu aktivieren. Die erfindungsgemäße Duscheinrichtung umfasst vorteilhafterweise ein Duschelement, das sich über die offen Seite des Beckens, und vorteilhafterweise in Richtung der Längserstreckung der Trägereinrichtung erstreckt. Ferner sind Mittel vorgesehen, die das Duschelement über der offenen Seite des Beckens verschwenken und ein Fluid zu dem Duschelement transportieren. Das Duschelement selbst weist mindestens eine Öffnung auf, die in Richtung der zu reinigenden Wafer, insbesondere auf die Zwischenräume, gerichtet ist. Durch diese Öffnung strömt das Fluid auf die Zwischenräume des Substratblocks. Für den Reinigungsprozess sind als Prozessparameter die Menge an Fluid und dessen Stömungsgeschwindigkeit bestimmend. Beide Parameter können über geeignete bekannte Mittel variiert werden. Nach einer bevorzugten Ausführungsform verfügt das Duschelement über eine schlitzartige Austrittsöffnung, die sich besonders bevorzugt über die gesamte Länge des Elementes erstreckt. Diese besondere Ausgestaltung ermöglicht die Ausbringung einer großen Fluidmenge, die hinsichtlich ihres Druck-Mengenverhältnisses weitgehend homogen ist. Auf diese Weise kann der Druck des Fluids an der Austrittsöffnung des Duschelements auf einen Wert zwischen 0,1 und 1,0 bar, vorzugsweise auf einen Wert zwischen 0,2 und 0,5 bar eingestellt werden.

Erfindungsgemäß wird nun für den Reinigungsprozess, nämlich für das Entfernen der Slurry aus den Zwischenräumen, wahlweise entweder die Duscheinrichtung relativ zur feststehenden Trägereinrichtung oder die Trägereinrichtung relativ zur feststehenden Duscheinrichtung bewegt. Alternativ kann auch vorgesehen werden, dass sowohl die Trägereinrichtung als auch die Duscheinrichtung relativ zueinander bewegt werden.

Damit ein Durchfließen des Fluidstroms durch die Zwischenräume möglich ist, wird die Trägereinrichtung zunächst derart positioniert, dass die jeweils offenen Seiten nach oben zur Öffnung des Beckens, zu einer Seitenwand des Beckens und in Richtung des Bodens des Beckens weisen. Nach einem vorgesehenen Zeitintervall verschwenkt die Trägereinrichtung um 180 Grad, so dass wieder der Zustand erreicht ist, dass die jeweils offenen Seiten nach oben zur Öffnung des Beckens, zu einer Seitenwand des Beckens und in Richtung des Bodens des Beckens weisen. Im Gegensatz zur vorherigen Situation zeigt die bisher in Richtung Boden des Beckens positionierte Seite nun jedoch zur offenen Seite des Beckens und damit zu dem Duschelement, während die bisher nach oben gerichtete Seite nun in Richtung des Bodens des Beckens ausgerichtet ist. Durch mehrere Schwenkbewegungen zwischen diesen beiden beschriebenen Positionen wird erreicht, dass die Slurry sowohl von der einen als auch von der anderen Seite aus den Zwischenräumen gespült wird.

Durch einen erhöhten Volumenstrom des Fluids ergibt sich weiterhin der Vorteil, dass die an den freien Enden zusammenklebenden Wafer in einem Abstand zueinander gehalten werden.

Ein weiterer Vorteil eines hohen Volumenstroms besteht darin, dass die Wafer zumindest geringfügig vibrieren, so dass sich die an der Oberfläche eines Wafers anhaftende Slurry einfacher lösen kann.

Bei einer bevorzugten Ausführungsform der erfindungsgemäßen Vorrichtung ist vorgesehen, dass das Duschelement sowohl um seine eigene Achse als auch örtlich über der Öffnung des Beckens schwenkbar ist.

Zur Optimierung des Reinigungsprozesses ist mindestens eine Ultraschalleinrichtung vorgesehen, die innerhalb des Beckens wahlweise stationär oder bewegbar angeordnet ist. Die Ultraschallquellen können ferner schräg oder parallel zu den Wafern ausgerichtet bzw. angeordnet sein. Dieser Reinigungsprozess schließt sich vorteilhafterweise unmittelbar an den Reinigungsprozess mit dem Duschelement an. Für die Durchführung dieses Prozesses ist es notwendig, dass das Becken, in dem die Trägereinrichtung angeordnet ist, mit Fluid gefüllt wird. Vorzugsweise wird ein kaltes Fluid verwendet, um eine optimale Übertragung der Ultraschallwellen zu ermöglichen. Vorzugsweise wird die Temperatur auf einen Wert zwischen 15 und 25 °C eingestellt, um chemische Reaktionen zu unterbinden und eine im Wesentlichen mechanische Behandlung zu gewährleisten.

Der Reinigungsprozess mit Ultraschallwellen kann vorzugsweise durch eine stationäre Querströmungseinrichtung zur Erzeugung eines Fluidstroms innerhalb des Beckens unterstützt werden. Die Querströmeinrichtung ist derart ausgebildet, dass der Fluidstrom in die jeweiligen Zwischenräume zweier benachbarter Wafer gerichtet ist und die durch den Ultraschall herausgelösten Teilchen wegschwemmt.

Nach der Ultraschallbehandlung des Substratblocks wird das Becken entleert, und ein weiterer Reinigungsprozess mit dem Duschelement beginnt. Der Prozess kann je nach Bedarf wiederholt werden, indem sich die Zyklen "Reinigungsprozess mit Duschelement" und "Reinigungsprozess mit Ultraschall" entsprechend abwechseln.

Eine besondere Ausbildung der Erfindung sieht vor, dass der Substratblock zunächst unter Verwendung der Duscheinrichtung mit einem warmen, gewünschtenfalls geeignete chemische Zusätze wie z.B. Tenside enthaltenden Fluid gereinigt wird, wobei dessen Temperatur vorzugsweise zwischen 35 und 40°C beträgt. Anschließend findet die Ultraschallreinigung innerhalb eines kalten Fluids statt. Beide Prozesse wiederholen sich gegebenenfalls. Als letzter Prozess ist ein Reinigungsprozess unter Verwendung der Duscheinrichtung mit einem kalten Fluid vorgesehen. Letzteres bringt den Vorteil mit sich, dass durch das Duschen mit einem kalten Fluid verhindert wird, dass die Wafer "austrocknen" und so eventuell übrig gebliebene Slurry fest an den Wafern anhaftet.

Das Duschfluid ist erfindungsgemäß wässrig und wird vorzugsweise auf eine Temperatur zwischen 15 und 40°C eingestellt, wobei eine Temperatur zwischen 30 und 40°C besonders bevorzugt ist. Vorzugsweise umfasst es geeignete nicht-schäumende, nicht-ionische Tenside in einer Menge von 0 bis 1 Vol.%, wobei eine Menge von 0,1 bis 0,5 Vol.%, bezogen auf die gesamte Fluidmenge, besonders bevorzugt ist. Vorzugsweise weist das bzw. weisen die Tenside einen (gemittelten) pH-Wert von etwa 13,0 auf, wodurch der pH-Wert des Duschfluids vorteilhaft auf einen bevorzugten Wert kleiner 12,0, besonders bevorzugt auf einen Wert zwischen 10,5 und 11,0 eingestellt werden kann. Ferner kann das Duschfluid Lauge oder Säure sowie gewünschtenfalls weitere Chemikalien umfassen.

Gewünschtenfalls kann das erfindungsgemäße Verfahren in einer bevorzugten Ausführungsform noch einen weiteren Verfahrensschritt der Kleberablösung umfassen. Hierzu wird die Trägereinrichtung ggfs. mit der Hilfseinrichtung in ein Behandlungsbecken überführt, welches eine in Abhängigkeit von der Beschaffenheit des verwendeten Klebers geeignete Flüssigkeit beinhaltet. Als besonders geeignet hat sich beispielsweise die Verwendung einer Essigsäure enthaltenden wässrigen Flüssigkeit erwiesen, deren Temperatur und pH-Wert besonders bevorzugt auf Werte um 40°C bzw. 3,0 bis 4,0 eingestellt sind. Anschließend werden die Wafer gespült, was vorzugsweise dadurch erfolgt, dass sie mit der Hilfseinrichtung in ein mit Wasser gefülltes Spülbecken überführt werden.

Ein weiterer wesentlicher Vorteil des Verfahrens ist, dass es sich in einen nachfolgenden Bearbeitungsprozess der Wafer einfach eingliedern lässt. Besonders vorteilhaft hat sich herausgestellt, dass die Prozessparameter erfindungsgemäß genau und reproduzierbar eingestellt werden können, wodurch die Behandlung auch größerer Stückzahlen auf gleichem Qualitätsniveau ermöglicht wird.

Weitere vorteilhafte Ausgestaltungen gehen aus der nachfolgenden Beschreibung sowie den Zeichnungen und den Ansprüchen hervor.

### Zeichnungen

Es zeigen:
- Fig. 1: eine schematische Ansicht der Trägereinrichtung, im Wesentlichen bestehend aus dem zu reinigenden Substratblock;
- Fig. 2: eine perspektivische Ansicht einer Halteeinrichtung zur Aufnahme der Trägereinrichtung gemäß Fig. 1;
- Fig. 3: eine perspektivische Ansicht einer Halteeinrichtung, gegenüber Fig. 2 mit der bereits aufgenommenen Trägereinrichtung;
- Fig. 4: eine schematische Ansicht eines bevorzugten Ausführungsbeispiels der erfindungsgemäßen Vorrichtung;
- Fig. 5: eine schematische Ansicht eines bevorzugten Ausführungsbeispiels der erfindungsgemäßen Vorrichtung, jedoch gegenüber Fig. 4 bereits mit eingefügter Trägereinrichtung in Ausgangslage;
- Fig. 6[A-C]: eine schematische Darstellung des Reinigungsprozesses mit der Duscheinrichtung.

### Beschreibung eines Ausführungsbeispiels

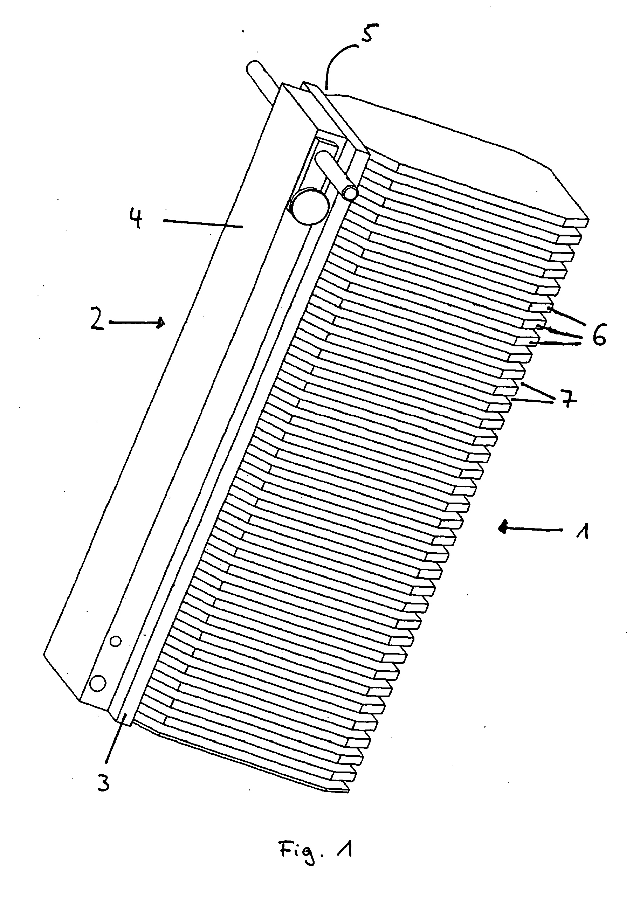

In Fig. 1 ist ein zu reinigender Substratblock 1 dargestellt. Der Substratblock 1 ist auf einer Trägereinrichtung 2 aufgebracht, die aus einer Glassplatte 3 sowie einem Befestigungselement 4 besteht. Der Substratblock 1 ist bei dem hier dargestellten Ausführungsbeispiel mit seiner einen Seite 5 flächig auf der Glasplatte 3 aufgeklebt. Durch den bereits durchgeführten Sägeprozess, dessen Schnitte bis in die Glasplatte 3 hineinreichen, entstehen einzelne Substrate, die auch als Wafer 6 bezeichnet werden. Zwischen den einzelnen Wafern 6 entsteht jeweils ein Zwischenraum 7, in dem sich die sogenannte Slurry (in den Zeichnungen nicht dargestellt) befindet, die durch den erfindungsgemäßen Reinigungsprozess entfernt werden soll.

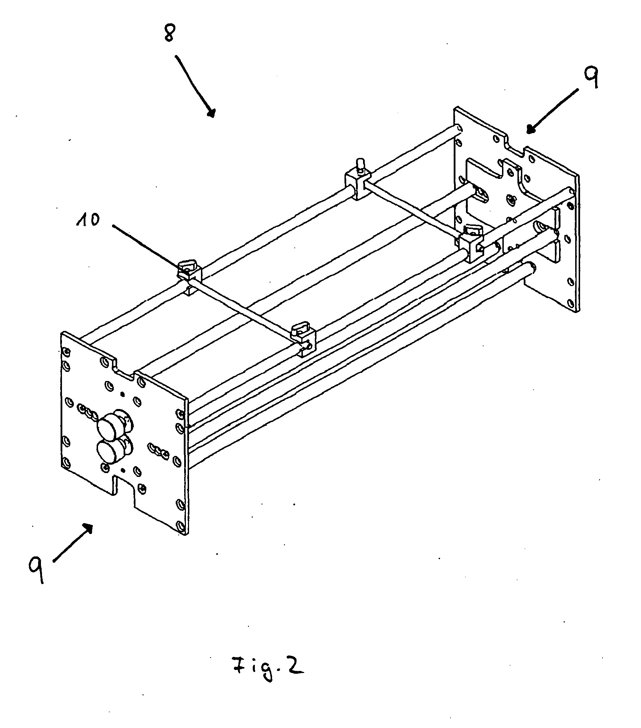

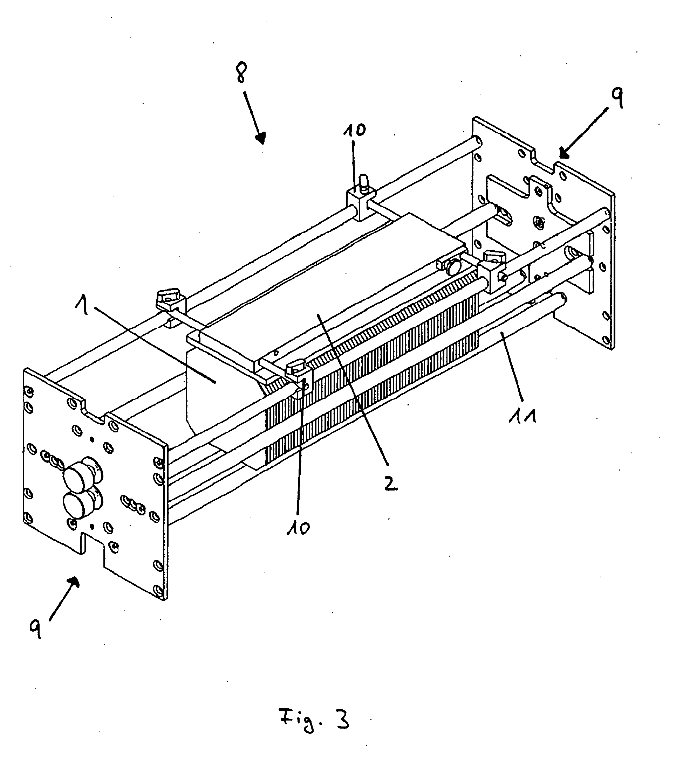

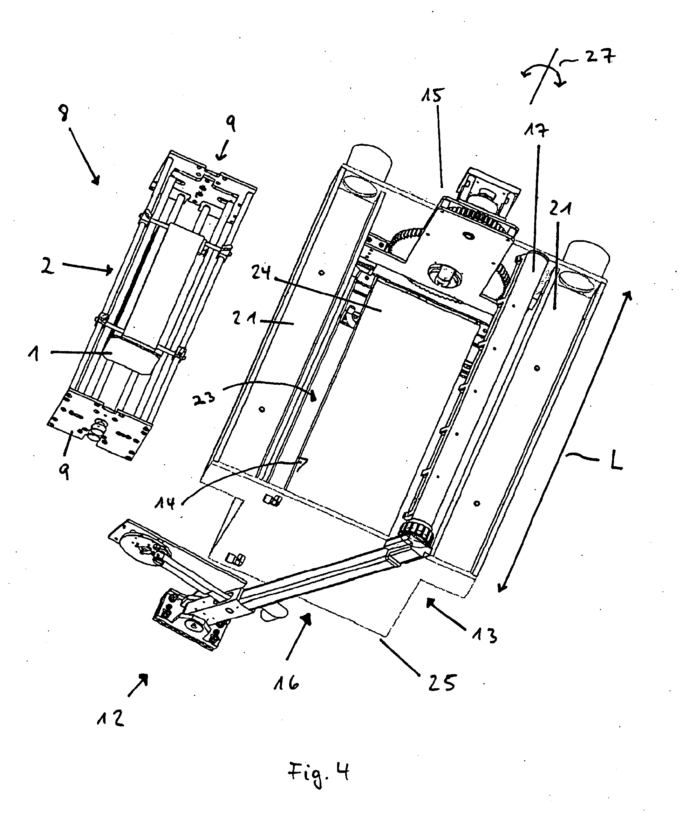

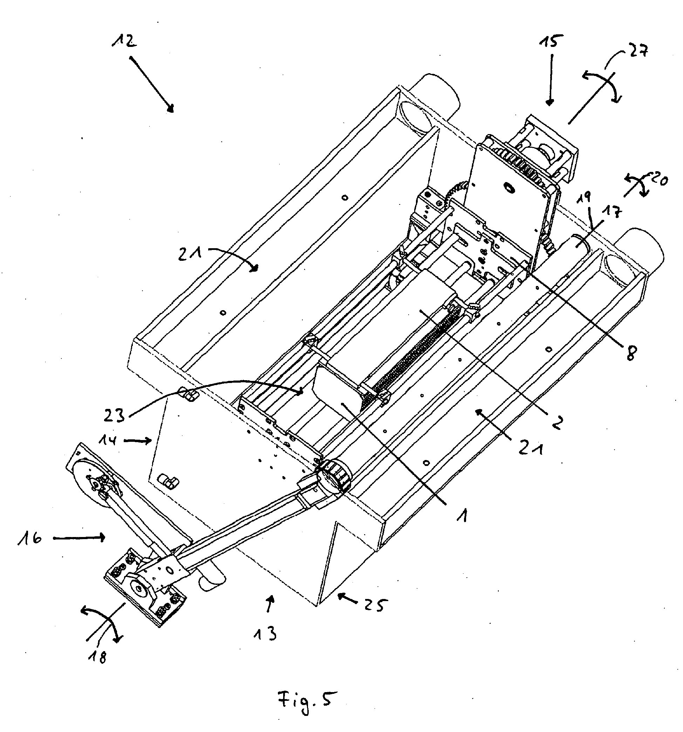

Um den mit der Trägereinrichtung 2 verbundenen Substratblock 1 an die erfindungsgemäße Vorrichtung, wie sie in den Fig. 4 und 5 dargestellt ist, übergeben zu können, wird die Trägereinrichtung 2 mit einer Hilfseinrichtung 8, wie sie in Fig. 2 und 3 dargestellt ist, übergeben. Die Hilfseinrichtung 8 umfasst seitlich angeordnete Mittel 9, die mit der Vorrichtung gemäß den Fig. 4 und 5 zusammenwirken. Um unterschiedlich große Trägereinrichtungen 2 aufnehmen zu können, ist vorgesehen, eine Aufnahmeeinrichtung 10 bereitzustellen, die flexibel in ihrer Lage zur Aufnahme der Trägereinrichtung 2 positionierbar ist. Zudem ist die Hilfseinrichtung 8 derart gestaltet, dass der Substratblock 1 gemäß Darstellung in Fig. 3 eine geschützte Lage gegen ungewolltes Anstoßen an einen Gegenstand einnimmt. Bei dem hier dargestellten Ausführungsbeispiel sind Stangen 11 als Verbindungselemente zwischen den vorgesehenen Mitteln 9 angeordnet, die den Substratblock 1 zwischen sich einschließen.

Um den Reinigungsprozess durchzuführen, ist die Vorrichtung 12 gemäß Darstellung in den Fig. 4 und 5 mit der Hilfseinrichtung 8 zu beladen. Die Vorrichtung 12 selbst zeigt ein Gehäuse 13, das ein mit einem Fluid befüllbares Becken 14 umfasst. Das Becken 14 ist derart bemessen, dass die Hilfseinrichtung 8 vollständig von dem Becken 14 aufgenommen werden kann. Seitlich an dem Becken 14 sind Abtropfflächen 21 vorgesehen.

Innerhalb des Beckens 14 ist eine Schwenkeinrichtung 15 vorgesehen, die die Eigenschaft aufweist, die Hilfseinrichtung 8 an den entsprechenden Mitteln 9 aufzunehmen und in und gegen die Pfeilrichtung 27 zu verschwenken.

Ferner weist die Vorrichtung 12 eine Duscheinrichtung 16 auf. Die Duscheinrichtung 16 besteht im Wesentlichen aus einem Duschelement 17, das sich in Richtung L und parallel zur Längserstreckung der Trägereinrichtung 2 erstreckt. Das Duschelement 17 ist vorzugsweise an seinen beiden Stirnseiten über Mittel geführt und wird in und gegen die Pfeilrichtung 18 verschwenkt, so dass sich der aus dem Duschelement 17 austretende Fluidstrom in das Becken 12 ergießt. Bei einer besonderen Ausführungsform verschwenkt das Duschelement 17 zusätzlich um seine eigene Achse 19 in und gegen die Pfeilrichtung 20. Besonders bevorzugt ist die in Grundstellung nach unten weisende Austrittsöffnung schlitzförmig ausgestaltet.

Bei dem in den Fig. 4 und 5 dargestellten Ausführungsbeispiel ist ferner vorgesehen, dass innerhalb des Beckens 14 Querströmungseinrichtungen vorgesehen sind. Diese Querströmungseinrichtungen weisen düsenartige Ausbildungen auf, die innerhalb des Beckens 14 zur Reinigung des Substratblocks 1 eine Querströmung erzeugen.

Ferner ist auf der Bodenseite des Gehäuses 13 eine Ultraschalleinrichtung 23 mit Ultraschallquellen 24 vorgesehen. Diese Ultraschalleinrichtung 23 wird je nach Bedarf zu- oder abgeschaltet und dient dazu, zusätzlich die in den Zwischenräumen 7 befindliche Slurry aufzulockern bzw. zu entfernen.

Alternativ zu der in den Fig. 4 und 5 dargestellten Ultraschalleinrichtung 23 kann vorgesehen werden, dass anstelle des stationären festen Einbaus eine mobile Ultraschalleinrichtung vorgesehen ist, die auch innerhalb des Beckens 14 in beliebiger Stellung verfahrbar ist.

### Funktionsweise:

Der Reinigungsprozess gestaltet sich wie folgt:
Nachdem die Trägereinrichtung 2 zusammen mit der Hilfseinrichtung 8 in die Vorrichtung 12 eingebracht worden ist (Fig. 4 und 5), nimmt die Trägereinrichtung 2 eine Stellung ein, durch die die einzelnen Wafer 6 in Richtung des Bodens 25 gerichtet sind. Dies bedeutet, dass die Zwischenräume 7 jeweils zu den Seiten und in Richtung Boden 25 des Beckens 14 offen sind.

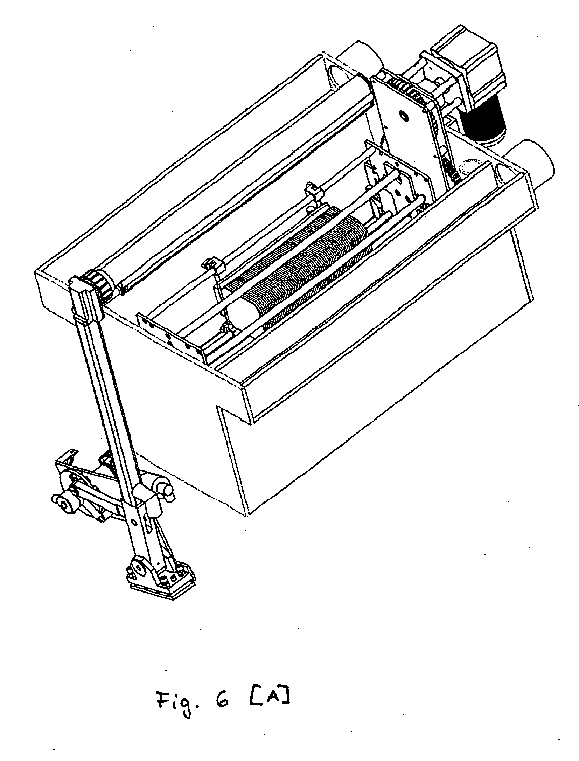

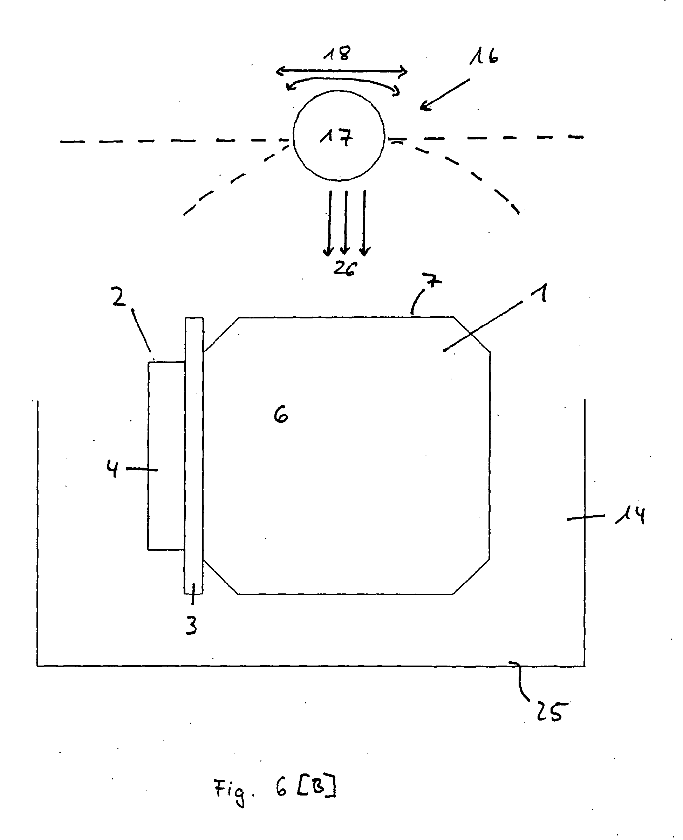

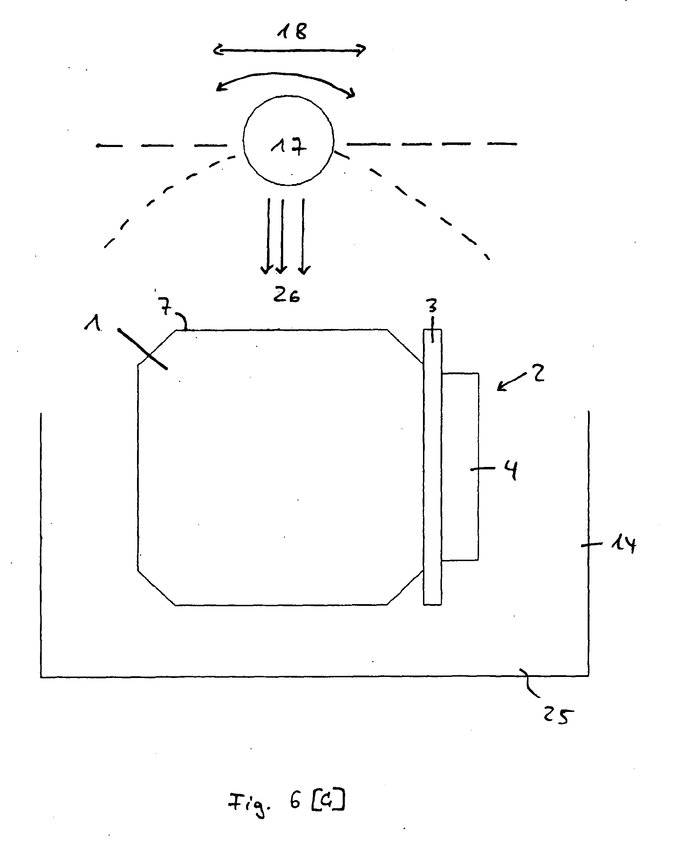

Der Reinigungsprozess beginnt, indem die Duscheinrichtung 16 aktiviert wird und der Substratblock 1 zumindest ungefähr die Position einnimmt, wie sie in Fig. 6B dargestellt ist. Diese Position zeichnet sich dadurch aus, dass der aus dem Duschelement 17 austretende Fluidstrom 26 in die jeweiligen Zwischenräume 7 gelangt, durch diese hindurchfließt und in Richtung Boden 25 des Beckens 14 wieder austreten kann. Damit kann die Slurry auf diese Weise aus den jeweiligen Zwischenräumen 7 entfernt werden. Bei einer Wiederholung dieses Reinigungsprozesses verschwenkt der Substratblock 1 um 180 Grad, so dass er die in Fig. 6C dargestellte Position einnimmt. Auch hier beginnt wieder der Duschvorgang, in dem der Fluidstrom 26 aus dem Duschelement 17 austritt, in die jeweiligen Zwischenräume 7 gelangt, durch diese hindurchfliesst und bodenseitig wieder austritt. Je nach Verschmutzungsgrad können diese Verfahrensschritte beliebig oft wiederholt werden. Der Fluidstrom 26 selbst ist temperiert und kann Temperaturen zwischen 25 Grad und 40 Grad Celsius aufweisen.

Anschließend findet eine Ultraschallreinigung mit der Ultraschalleinrichtung 23 statt. Hierzu ist es notwendig, dass das Becken 14 zur Übertragung der Schallwellen von den Ultraschallquellen 24 mit einem Fluid gefüllt wird.

Im Anschluss hieran wird das Becken 14 entleert und der bereits beschriebene Duschvorgang beginnt.

Auf diese Weise können sich die einzelnen Schritte beliebig wiederholen.

Vor der Entnahme des dann vorgereinigten (precleaned) Substratblocks 1 findet nochmals ein Duschvorgang statt, jedoch mit einem kalten Fluid. Dadurch kann verhindert werden, dass noch vorhandene Slurry zumindest unmittelbar antrocknet.

Durch die erfindungsgemäße Vorrichtung 1 und das Anwenden des erfindungsgemäßen Verfahrens ist es möglich geworden, dünne, bruchempfindliche Scheiben selbsttätig (automatisch) vorzureinigen. Insbesondere bei der Herstellung von Wafern für die Halbleiter- und Solarindustrie ist es notwendig, die sogenannte Slurry unmittelbar nach dem Sägeprozess zu entfernen. Diese Slurry haftet sehr stark an der Oberfläche des jeweiligen Wafers, weshalb bisher eine manuelle Behandlung durchgeführt werden musste. Durch das erfindungsgemäße Verfahren ist es jedoch möglich geworden, eine qualitativ sehr gute und automatisierte Vorreinigung der Wafer 6 zu ermöglichen.

Die vorliegende Erfindung wurde im Hinblick auf die Behandlung von Siliziumwafern dargelegt. Selbstverständlich können auch scheibenförmige Substrate aus anderen Materialien wie z.B. Kunststoff erfindungsgemäß bearbeitet werden.

### BEZUGSZEICHENLISTE

1. Substratblock
2. Trägereinrichtung
3. Glasplatte
4. Befestigungselement
5. eine Seite
6. Wafer
7. Zwischenraum
8. Hilfseinrichtung
9. Mittel
10. Aufnahmeeinrichtung
11. Stangen
12. Vorrichtung
13. Gehäuse
14. Becken
15. Schwenkeinrichtung
16. Duscheinrichtung
17. Duschelement
18. Pfeilrichtung
19. Achse
20. Pfeilrichtung
21. Abtropfflächen
22. -
23. Ultraschalleinrichtung
24. Ultraschallquellen
25. Boden
26. Fluidstrom
27. Pfeilrichtung
L Längserstreckung

## Patentansprüche

1. Vorrichtung zum Reinigen von dünnen Wafern (6), die in einem gesägten Substratblock (1) vorliegen, wobei die Wafer (6) des Substratblockes (1) mit ihrer einen Seite an einer Trägereinrichtung (2) fixiert sind und jeweils zwischen zwei benachbarten Wafern ein Zwischenraum (7) ausgebildet ist, bestehend im Wesentlichen aus:
- einer Duscheinrichtung (16), mit der Fluid in die jeweiligen Zwischenräume (7) eingebracht wird,
- einem Becken (14), das mit Fluid befüllbar und derart bemessen ist, das es die Trägereinrichtung (2) aufnimmt,
**dadurch gekennzeichnet, dass** ferner eine Schwenkeinrichtung (15) zum Rotieren der Trägereinrichtung (2) mit dem Substratblock (1) vorgesehen ist, wobei wahlweise entweder die Duscheinrichtung (16) relativ zur feststehenden Trägereinrichtung (2), oder die Trägereinrichtung (2) relativ zur feststehenden Duscheinrichtung (16), oder sowohl die Trägereinrichtung (2) als auch die Duscheinrichtung (16) relativ zueinander bewegbar sind.

2. Vorrichtung nach Anspruch 1, **dadurch gekennzeichnet, dass** mindestens eine Ultraschalleinrichtung (23) vorgesehen ist, die innerhalb des Beckens (14) wahlweise stationär oder bewegbar angeordnet ist.

3. Vorrichtung nach einem der vorhergehenden Ansprüche, **dadurch gekennzeichnet, dass** die Duscheinrichtung (16) im Wesentlichen ein Duschelement (17) umfasst, das stabförmig ausgebildet ist und mit einer Öffnung oder mehreren Öffnungen versehen ist, die am Becken (14) angeordnet ist bzw. sind und sich über mindestens einen Teil des Beckens (14) erstrecken, wobei die Öffnung oder die Öffnungen in Richtung der Trägereinrichtung (2) weisen.

4. Vorrichtung nach Anspruch 1 oder 2, **dadurch gekennzeichnet, dass** die Duscheinrichtung (16) ein Duschelement (17) umfasst, das schlitzförmig ausgebildet ist und sich über die gesamte Länge der Duscheinrichtung erstreckt.

5. Vorrichtung nach einem der vorhergehenden Ansprüche, **dadurch gekennzeichnet, dass** innerhalb des Beckens (14) mindestens eine stationäre Querströmungseinrichtung zur Erzeugung eines Fluidstroms angeordnet ist, wobei die Querströmungseinrichtung derart ausgebildet ist, dass der Fluidstrom in die Zwischenräume (7) gerichtet ist.

6. Vorrichtung nach Anspruch 5, **dadurch gekennzeichnet, dass** mehrere einzelne Querströmungseinrichtungen in Bezug auf die Tiefe des Becken (14) auf unterschiedlichen Niveaus angeordnet sind.

7. Vorrichtung nach Anspruch 5 oder 6, **dadurch gekennzeichet, dass** die Querströmungseinrichtungen innerhalb des Beckens (14) höhenverstellbar sind.

8. Vorrichtung nach einem der Ansprüche 2 bis 7, **dadurch gekennzeichnet, dass** die Ultraschalleinrichtung (23) Ultraschallquellen (24) umfasst, die schräg zur horizontalen Ausrichtung der Trägereinrichtung (2) angeordnet sind.

9. Vorrichtung nach einem der Ansprüche 2 bis 8, **dadurch gekennzeichnet, dass** die Ultraschallquellen (24) rotierend angeordnet sind.

10. Verfahren zum Reinigen von dünnen Wafern (6), die in einem gesägten Substratblock (1) vorliegen, mittels einer Vorrichtung, wobei die Wafer (6) des Substratblockes (1) mit ihrer einen Seite an einer Trägereinrichtung (2) fixiert sind und jeweils zwischen zwei benachbarten Wafern ein Zwischenraum (7) ausgebildet ist, und wobei die Vorrichtung im Wesentlichen besteht aus einer Duscheinrichtung (16), mit der Fluid in die jeweiligen Zwischenräume (7) eingebracht wird, und einem Becken (14), das mit Fluid befüllbar und derart bemessen ist, das es die Trägereinrichtung (2) aufnimmt,
**dadurch gekennzeichnet, dass** für die Vorrichtung ferner eine Schwenkeinrichtung (15) zum Rotieren der Trägereinrichtung (2) mit dem Substratblock (1) vorgesehen ist, umfassend die folgenden Verfahrensschritte:
a) Einführen der Trägereinrichtung (2) mit dem Substratblock (1) in das leere oder teilgefüllte Becken (14);
b) Durchführen des Reinigungsprozesses mit der Duscheinrichtung (16), wobei wahlweise entweder die Duscheinrichtung (16) relativ zur feststehenden Trägereinrichtung (2), oder die Trägereinrichtung (2) relativ zur feststehenden Duscheinrichtung (16), oder sowohl die Trägereinrichtung (2) als auch die Duscheinrichtung (16) relativ zueinander bewegt werden.

11. Verfahren nach Anspruch 10, **dadurch gekennzeichnet, dass** es als zusätzlichen Verfahrensschritt c) das Durchführen des Reinigungsprozesses mit mindestens einer innerhalb des Beckens (14) angeordneten Ultraschalleinrichtung (23) in Anwesenheit von Fluid umfasst.

12. Verfahren nach Anspruch 11, **dadurch gekennzeichnet, dass** der Verfahrensschritt b) vor und nach dem Verfahrensschritt c) durchgeführt wird.

13. Verfahren nach Anspruch 11 oder 12, **dadurch gekennzeichnet, dass** die Verfahrensschritte b) und c) mehrmals nacheinander durchgeführt werden.

14. Verfahren nach einem der Ansprüche 10 bis 13, **dadurch gekennzeichnet, dass** der Verfahrensschritt b) mit einem warmem Fluid erfolgt.

15. Verfahren nach einem der Ansprüche 11 bis 14, **dadurch gekennzeichnet, dass** der Verfahrensschritt c) mit einem kalten Fluid erfolgt.

16. Verfahren nach einem der Ansprüche 10 bis 15, **dadurch gekennzeichnet, dass** der letzte Reinigungsprozess ein Durchführen des Reinigungsprozesses mit der Duscheinrichtung (16) mit einem kalten Fluid umfasst.

## Claims

1. Apparatus for the cleaning of thin wafers (6) that are present in a sawn substrate block (1), wherein the wafers (6) of the substrate block (1) are fixed with their one side to a carrier device (2) and an interspace (7) is respectively formed between two adjacent wafers, substantially consisting of:
- a shower device (16), by which fluid is injected into the respective interspaces (7),
- a basin (14) that can be filled with fluid and is dimensioned such that it houses the carrier device (2),
**characterized in that** a rotation device (15) for rotating the carrier device (2) with the substrate block (1) is further provided, wherein optionally either the shower device (16) can be moved in relation to the immobile carrier device (2), or the carrier device (2) can be moved in relation to the immobile shower device (16), or both the carrier device (2) as well as the shower device (16) can be moved in relation to each other.

2. Apparatus according to claim 1, **characterized in that** at least one ultrasonic device (23) is provided that is arranged within the basin (14) and optionally is immobile or movable.

3. Apparatus according to any of the preceding claims, **characterized in that** the shower device (16) substantially comprises a shower element (17), that is designed rod-like and has one or more openings that are arranged at the basin (14) and extend along at least a part of the basin (14), wherein the opening or the openings point in direction of the carrier device (2).

4. Apparatus according to claim 1 or 2, **characterized in that** the shower device (16) comprises a shower element (17) that is designed slit-like and extends along the entire length of the shower device.

5. Apparatus according to any of the preceding claims, **characterized in that** at least one immobile cross flow device is present within the basin (14) for generation of a fluid stream, wherein the cross flow device is designed such that the fluid stream is directed into the interspaces (7).

6. Apparatus according to claim 5, **characterized in that** several individual cross flow devices are arranged on different levels with respect to the depth of the basin (14).

7. Apparatus according to claim 5 or 6, **characterized in that** the cross flow devices within the basin (14) are vertically adjustable.

8. Apparatus according to any of claims 2 to 7, **characterized in that** the ultrasonic device (23) comprises ultrasonic sources (24) that are arranged inclined to the horizontal orientation of the carrier device (2).

9. Apparatus according to any of claims 2 to 8, **characterized in that** the ultrasonic sources (24) are arranged rotating.

10. Method for the cleaning of thin wafers (6) that are present in a sawn substrate block (1), by means of an apparatus, wherein the wafers (6) of the substrate block (1) are fixed with their one side to a carrier device (2) and an interspace (7) is respectively formed between two adjacent wafers, and wherein the apparatus substantially consists of a shower device (16) by which fluid is injected into the respective interspaces (7), and a basin (14) that can be filled with fluid and is dimensioned such that it houses the carrier device (2), **characterized in that** a rotation device (15) for rotating the carrier device (2) with the substrate block (1) is further provided, comprising the following process steps:
a) insertion of the carrier device (2) with the substrate block (1) into the empty or partly filled basin (14);
b) carrying out of the cleaning process with the shower device (16), wherein optionally either the shower device (16) is moved in relation to the immobile carrier device (2), or the carrier device (2) is moved in relation to the immobile shower device (16), or both the carrier device (2) as well as the shower device (16) are moved in relation to each other.

11. Process according to claim 10, **characterized in that** it comprises as an additional process step c) carrying out the cleaning process with at least one ultrasonic device (23) which is arranged within the basin (14) in the presence of fluid.

12. Method according to claim 11, **characterized in that** process step b) is carried out before and after process step c).

13. Method according to claim 11 or 12, **characterized in that** process steps b) and c) are carried out several times one after the other.

14. Method according to any of claims 10 to 13, **characterized in that** process step b) is performed with a warm fluid.

15. Method according to any of claims 11 to 14, **characterized in that** process step c) is performed with a cold fluid.

16. Method according to any of claims 10 to 15, **characterized in that** the last cleaning process comprises carrying out of the cleaning process with the shower device (16) with a cold fluid.

## Revendications

1. Appareil pour le nettoyage des plaquettes fines (6) qui sont présentes dans un bloc de substrat découpé (1), les plaquettes (6) du bloc de substrat (1) étant fixées par un de leur coté à un dispositif porteur (2) et un interstice (7) étant formé entre chaque paire de plaquettes voisines, constitué principalement de:
- un dispositif de douche (16) par lequel un fluide est amené dans chaque interstice (7),
- un bassin (14) qui peut être rempli de fluide et de dimensions telles qu'il peut contenir le dispositif porteur (2),
**caractérisé en ce que** de plus un dispositif de basculement (15) pour tourner le dispositif porteur (2) avec le bloc de substrat (1) est fourni, dans lequel au choix soit le dispositif de douche (16) est mobile par rapport au dispositif porteur fixe (2), soit le dispositif porteur (2) est mobile par rapport au dispositif de douche (16) fixe, soit le dispositif porteur (2) ainsi que le dispositif de douche (16) sont mobiles l'un par rapport à l'autre.

2. Appareil selon la revendication 1, **caractérisé en ce que** au moins un dispositif à ultrasons (23) est fourni, installé à l'intérieur du bassin (14), au choix stationnaire ou mobile.

3. Appareil selon l'une des revendications précédentes, **caractérisé en ce que** le dispositif de douche (16) comprend essentiellement un élément de douche (17) conçu en forme de bâton et percé par un ou plusieurs orifices, qui est, respectivement sont, placé(s) sur le bassin (14) et qui se prolongent sur au moins une partie du bassin (14), l'orifice ou les orifices étant dirigés vers le dispositif porteur (2).

4. Appareil selon la revendication 1 ou la revendication 2, **caractérisé en ce que** le dispositif de douche (16) comprend un élément de douche (17) en forme de fente qui se prolonge sur la longueur totale du dispositif de douche.

5. Appareil selon l'une des revendications précédentes, **caractérisé en ce que** au moins un dispositif stationnaire d'écoulement transversal est présent à l'intérieur du bassin (14) pour générer un courant fluidique, le dispositif d'écoulement transversal étant formé de telle manière que le courant fluidique est dirigé dans les interstices (7).

6. Appareil selon la revendication 5, **caractérisé en ce que** plusieurs dispositifs d'écoulement transversal individuels sont présents à différents niveaux par rapport à la profondeur du bassin (14).

7. Appareil selon la revendication 5 ou la revendication 6, **caractérisé en ce que** les dispositifs d'écoulement transversal sont réglables en hauteur à l'intérieur du bassin (14).

8. Appareil selon l'une des revendications 2 à 7, **caractérisé en ce que** le dispositif à ultrasons (23) comprend des sources d'ultrasons (24) qui sont placées en biais par rapport à l'orientation horizontale du dispositif porteur (2).

9. Appareil selon l'une des revendications 2 à 8 **caractérisé en ce que** les sources d'ultrasons (24) sont placées de telle manière qu'elles peuvent tourner.

10. Procédé pour le nettoyage des plaquettes fines (6) qui sont présentes dans un bloc de substrat découpé (1), par l'intermédiaire d'un appareil, les plaquettes (6) du bloc de substrat (1) étant fixées par un de leurs cotés à un dispositif porteur (2) et un interstice (7) étant formé entre chaque paire de plaquettes voisines, et l'appareil étant constitué principalement d'un dispositif de douche (16) par lequel un fluide est amené dans chaque interstice (7), et un bassin (14) qui peut être rempli de fluide et de dimensions telles qu'il peut contenir le dispositif porteur (2),
**caractérisé en ce que** de plus un dispositif de basculement (15) pour tourner le dispositif porteur (2) avec le bloc de substrat (1) est fourni pour l'appareil, comprenant les étapes de procédé suivantes :
a) introduire le dispositif porteur (2) avec le bloc de substrat (1) dans le bassin (14) vide ou rempli en partie ;
b) effectuer le processus de nettoyage avec le dispositif de douche (16), dans lequel au choix soit le dispositif de douche (16) est mobile par rapport au dispositif porteur fixe (2), soit le dispositif porteur (2) est mobile par rapport au dispositif de douche (16) fixe, soit le dispositif porteur (2) ainsi que le dispositif de douche (16) sont mobiles l'une par rapport à l'autre.

11. Procédé selon la revendication 10, **caractérisé en ce qu'**il comprend comme étape de procédé supplémentaire c) l'exécution du processus de nettoyage avec au moins un dispositif à ultrasons (23) placé à l'intérieur du bassin (14) en présence de fluide.

12. Procédé selon la revendication 11, **caractérisé en ce que** l'étape de procédé b) est effectuée avant et après l'étape de procédé c).

13. Procédé selon la revendication 11 ou la revendication 12, **caractérisé en ce que** les étapes de procédé b) et c) sont exécutées plusieurs fois l'une après l'autre.

14. Procédé selon l'une des revendications 10 à 13, **caractérisé en ce que** l'étape de procédé b) est effectuée avec un fluide chaud.

15. Procédé selon l'une des revendications 11 à 14, **caractérisé en ce que** l'étape de procédé c) est effectuée avec un fluide froid.

16. Procédé selon l'une des revendications 10 à 15, **caractérisé en ce que** le dernier processus de nettoyage comprend l'exécution d'un processus de nettoyage avec le dispositif de douche (16) avec un fluide froid.
